(19) Europäisches Patentamt
European Patent Office
Office européen des brevets

(11) **EP 2 247 172 B1**

(12) **EUROPÄISCHE PATENTSCHRIFT**

(45) Veröffentlichungstag und Bekanntmachung des Hinweises auf die Patenterteilung:
**30.01.2013 Patentblatt 2013/05**

(51) Int Cl.:
*H05K 7/20* (2006.01)　　　　*H01L 23/34* (2006.01)

(21) Anmeldenummer: **09158808.7**

(22) Anmeldetag: **27.04.2009**

(54) **Kühlsystem, Kühlplatte und Baugruppe mit Kühlsystem**

Cooling system, cooling board and assembly with cooling system

Système de refroidissement, plaque de refroidissement et composant doté d'un système de refroidissement

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(43) Veröffentlichungstag der Anmeldung:
**03.11.2010 Patentblatt 2010/44**

(73) Patentinhaber: **SIEMENS AKTIENGESELLSCHAFT**
**80333 München (DE)**

(72) Erfinder:
 • **Busch, Klaus**
　**92224 Amberg (DE)**
 • **Deinhardt, Günther**
　**92224 Amberg (DE)**
 • **Reinhard, Alexander**
　**92224 Amberg (DE)**
 • **Wiesner, Christoph**
　**92224 Amberg (DE)**

(56) Entgegenhaltungen:
DE-A1-102005 049 872　　US-A- 5 648 890
US-A- 5 787 576　　　　　US-A- 5 886 408

**Beschreibung**

Die Erfindung betrifft ein Kühlsystem umfassend einen Kühlkörper mit einer ersten Kontaktzone und einer zweiten Kontaktzone, welche ausgestaltet sind zur Aufnahme eines ersten Wärmestroms von einem ersten Bauteil und eines zweiten Wärmestroms von einem zweiten Bauteil, ein erstes Übertragungsmittel zur Übertragung des ersten Wärmestroms über die erste Kontaktzone in den Kühlkörper. Des Weiteren betrifft die Erfindung eine Kühlplatte umfassend eine erste Kontaktzone, eine zweite Kontaktzone, ausgestaltet zur Aufnahme eines ersten Wärmestroms von einem ersten Bauteil und eines zweiten Wärmestroms eines zweiten Bauteils.

Auch betrifft die Erfindung eine elektrische Baugruppe mit einer Leiterplatte, wobei die Baugruppe das Kühlsystem aufweist.

Aufgrund einer Miniaturisierung von Elektronikkomponenten, wird zunehmend eine höhere Packungsdichte/Funktionsdichte an elektronischen Komponenten/Bauteilen auf einer Flachbaugruppe, wie beispielsweise eine bestückte Leiterplatte, realisiert. Dies führt zu einer Erhöhung der Verlustleistung, da eine Gerätefunktionalität und damit eine Anzahl der verwendeten elektronischen Bauteile steigen. Auch der Einsatz von höher getakteten Mikroprozessoren führt zu einem Anstieg der Verlustleistung. Die Entwickler von Elektronikkomponenten und Flachbaugruppen stehen zur Optimierung der Einsatzmöglichkeiten und damit der Wirtschaftlichkeit dabei vor folgender Problematik: Erhöhung der Verlustleistung pro Baugruppe aufgrund steigender Packungsdichten und schnelleren Mikroprozessoren bei gleichzeitiger Minimierung der Geräteabmessungen. Dies führt zu einer überproportionalen Erhöhung der Verlustleistungsdichte, welche bei elektronischen Baugruppen als Verlustleistung pro Bauvolumen definiert ist. Bezogen auf eine Entwärmung von elektronischen Baugruppen besteht somit der Bedarf verbesserte Konzepte im Sinne der abzuführenden thermischen Verlustleistung bei gleichzeitiger optimaler Platzausnutzung zu entwickeln.

Nach dem derzeitigen Stand der Technik werden dazu elektronische Bauteile an eine Kühlplatte, einen Kühlkörper oder Gehäuseteilen thermisch kontaktiert. Über eine freie oder erzwungene Konvektion kann dann die Wärmeableitung vom wärmeabgebenden elektronischen Bauteil in den Kühlkörper und von dem Kühlkörper an die Umgebungsluft geschehen.

In vielen elektronischen Baugruppen oder Geräten besteht aus Platz- und Kostengründen die Notwendigkeit, mehrere elektronische Bauelemente an ein gemeinsames Kühlsystem thermisch zu kontaktieren.

Solch eine thermische Entwärmung wird in der US 5 787 576 A offenbart, es ist eine Kühlplatte gezeigt, ausgestaltet als eine Umhausung für eine Baugruppe, wobei die Umhausung zwei Gewindelöcher aufweist. In diese Gewindelöcher können Schrauben zum Erzeugen eines Anpressdruckes der Kühlplatte für mindestens zwei Bauteile gedreht werden.

In der EP 0 454 603 A2 wird ein Kühlsystem offenbart, bei welchem eine Mehrzahl von Chips über einen ersten rippenförmigen flexiblen Einsatz thermisch kontaktiert werden. Auf den ersten flexiblen Einsatz wird eine Gitterstruktur mit schräg gestellten Federarmen aufgebracht und auf diese Gitterstruktur wird ein zweiter flexibler Einsatz aufgebracht, welcher thermisch mit einer Oberschale des Kühlsystems kontaktiert, wobei die Oberschale mit einer Unterschale des Kühlsystems fest verschraubt wird. Nachteilig an dieser Lösung ist es, dass für den Einsatz auf einer Leiterplatte drei Übertragungsmittel zwischen einem wärmeabgebenden Bauteil und einer Kühlplatte angeordnet werden müssen.

Bei der Kontaktierung von mehreren elektronischen Bauteilen an eine gemeinsame Kühlplatte besteht die Problematik, dass durch die vorhandenen Maßtoleranzen der elektronischen Bauteile, die Kühlplatte nicht alle elektronischen Bauteile gleichzeitig thermisch optimal kontaktieren kann. Beispielsweise haben zwei elektronische Bauteile, welche auf einer Leiterplatte angeordnet sind, eine unterschiedliche Höhendifferenz, die thermisch überbrückt werden muss. Dies wird üblicherweise durch ein Thermal-Interface-Material (TIM) realisiert. Durch dieses Material, welches die Höhendifferenz ausgleicht, ist der thermische Entwärmungspfad zwar überbrückt, aber nicht optimal ausgelegt.

Es ist Aufgabe der Erfindung, einen aufgrund unterschiedlicher Toleranzlagen von Bauteilen entstehenden thermischen Widerstand in einem thermischen Entwärmungspfad zu reduzieren und damit eine Gesamtentwärmung zu optimieren.

Die Aufgabe wird für das eingangs genannte Kühlsystem dadurch gelöst, dass ein erstes Übertragungsmittel zwischen dem ersten Bauteil und dem Kühlkörper angeordnet ist und ein erstes Steckmittel aufweist, welches dergestalt ausgeformt ist, dass das erste Steckmittel mit einem im Kühlkörper angeordnetem ersten Durchführmittel eine erste Passung bildet, wobei mittels der ersten Passung ein Toleranzausgleich und ein Übertragungsweg des ersten Wärmestromes in den Kühlkörper realisiert ist. Die Steckmittel sind dabei in den Kühlkörper steckbar und bilden somit einen thermischen Steckverbinder, welcher eine axiale Beweglichkeit in der Passung zulässt und somit einen Toleranzausgleich ermöglicht. Die Toleranzen der elektronischen Bauteile können nun über den Effekt, dass die Steckmittel wie ein Schiebstück in den Kühlkörper einschiebbar sind, individuell ausgeglichen werden, ohne dass ein thermischer Übergangswiderstand sich dabei wesentlich verändert.

Beispielsweise stellt eine Unterseite eines Kühlkörpers eine ebene Fläche dar und kann bei vorhandenen Maßtoleranzen der elektrischen Bauteile zwangsläufig nur plan auf einem elektrischen Bauteil aufliegen, der Kühlkörper würde also, um beide elektrische Bauteile zu kontaktieren, eine Kippbewegung ausführen müssen. Dabei verliert der Kühlkörper aber wiederum den gewünschten planaren ebenen Kontakt zu einem zweiten zu entwärmenden Bauteil. Dadurch, dass das erste Übertragungsmittel ebenfalls planar mit dem ersten zu entwärmenden Bauteil verbunden ist und über die in den Kühlkörper hineinragenden Steckmittel verfügt, wird quasi ein teleskopartiger Wärmeübertragungsweg in dem Kühlkörper aufgebaut, welcher den Toleranzausgleich ermöglicht.

In einer vorteilhaften Ausgestaltung ist das Kühlsystem mit einem Übertragungsmittel versehen, welches eine Unterseite und eine Oberseite aufweist, wobei die Unterseite ausgestaltet ist um sich einer Kontur des ersten Bauteils anzupassen und die Oberseite mit einer Anordnung von Stiften und Stegen versehen ist. Bei einer Mehrzahl von vorzugsweise Stiften, beispielsweise in Form einer Matrix, vorzugsweise 10x10 Stiften, entsteht über den derart ausgestalteten thermischen Steckverbinder eine thermische Parallelschaltung, wobei sich der aus der thermischen Parallelschaltung errechnete Gesamtwiderstand als ein optimierter thermischer Gesamtwiderstand darstellt.

Ein dadurch realisierter thermischer Entwärmungspfad ist im Sinne einer abzuführenden Verlustleistung umso effektiver, je geringer der thermische Gesamtwiderstand, bestehend aus einer Vielzahl von parallel geschalteten thermischen Einzelwiderständen ist.

Zur weiteren Reduzierung des thermischen Gesamtwiderstandes ist vorteilhafterweise zwischen dem ersten Übertragungsmittel und dem Kühlkörper ein erstes Federelement angeordnet. Dieses Federelement dient einer Kontaktkrafterzeugung zwischen der Oberseite des Übertragungsmittels und dem Kühlkörper. Wird dabei das Federelement vorzugsweise als eine wellenförmige Blattfeder ausgestaltet, so wird die Erzeugung einer Kontaktkraft dadurch weiter erhöht.

Um den thermischen Gesamtwiderstand möglichst gering zu halten sind die Durchführmittel als eine Anordnung von einer Mehrzahl von Löchern, insbesondere Bohrungen, oder Schlitzen ausgestaltet.

Die mittels der Durchführmittel und der Steckmittel ausgestaltete Passung ist dabei als eine Spielpassung ausgestaltet. Vorzugsweise kann dabei die Anordnung der Durchführmittel als eine Lochkontur ausgestaltet sein. Diese Lochkontur ist identisch zu der Kontur der Steckmittel des ersten Übertragungsmittels ausgestaltet, aber in seinen Abmessungen und Dimensionierungen als eine Spielpassung ausgelegt.

Auch von Vorteil ist es, wenn die Passung zumindest abschnittsweise als ein Schiebstück ausgestaltet ist.

Mit Vorteil weist das Übertragungsmittel zumindest teilweise die thermisch gut leitenden Materialien Aluminium und/oder Kupfer und/oder Zink-Druckguß und/oder Graphit auf.

Ist das Übertragungsmittel derart ausgestaltet, dass es eine Basisplatte, auf der die Steckmittel im Wesentlichen senkrecht dazu angeordnet sind, aufweist, so ist diese Basisplatte mit Vorteil aus Graphit gefertigt. Graphit zeichnet sich durch einen hohen Wärmeleitwert von ca. 400 W/m K aus. Besonders bemerkbar macht sich dieser relativ hohe Wärmeleitwert, wenn das Graphit konstruktiv so aufgebracht oder angeordnet ist, dass dieser hohe Wärmeleitwert in einer parallelen Achse zu dem zu entwärmenden Bauteil zu erwarten ist. Das derartig ausgestaltete Übertragungsmittel bewirkt damit vorteilhaft eine "Wärmespreizung" in der Ebene, wodurch die Wärmeflussdichte und damit so genannte "hot spots" auf dem elektronischen Bauteil verringert werden.

Zur Befestigung des Kühlsystems auf einer Leiterplatte weist dieses in einer alternativen Ausgestaltung Befestigungsmittel auf. Befestigungsmittel können Gewindelöcher mit Schrauben, Klammern, Nuten usw. sein.

Die eingangs genannte Aufgabe wird ebenfalls durch die eingangs genannte Kühlplatte dadurch gelöst, dass bei der Kühlplatte zumindest die erste Kontaktzone mit Durchführmitteln versehen ist, um einen Toleranzausgleich bei einer Anordnung der Bauteile bezüglich ihrer Kontaktzonen im Hinblick auf eine gemeinsame Entwärmung der Bauteile zu ermöglichen. Derartige Kühlplatten können zur gemeinsamen Entwärmung von einer Vielzahl von elektronischen Bauteilen genutzt werden. Kühlplatten haben den Vorteil, dass sie gegenüber einem beispielsweise Rippenkühlkörper einen reduzierten Platzbedarf aufweisen. Des Weiteren können Kühlplatten bei elektronischen Baugruppen einen integrativen Bestandteil der Konstruktion einnehmen und somit für zusätzliche Stabilität oder einen Grundaufbau einer Baugruppe genutzt werden.

Als weitere Vorteile, die auch als Vorteile für das Kühlsystem zu sehen sind, ergeben sich, dass eine bewegliche Kühlkörper-Einheit einen automatischen Toleranzausgleich zwischen den verschieden hohen elektronischen Bauteilen und einer gemeinsamen Kühlplatte herstellt. Eine Qualität der thermischen Kontaktierung zwischen den elektronischen Bauteilen und der Kühlplatte ist unabhängig von der Lage des relativ zum Kühlkörper beweglichen Übertragungsmittels, wobei als Übertragungsmittel vorzugsweise ein so genannter heatspreader eingesetzt wird. Es ergeben sich eine kostengünstige Montage, weil keine Justierung oder Einstellung in Abhängigkeit der Ist-Maße der elektronischen Bauteile erforderlich sind. Weiterhin kann die Herstellung eines derartigen Kühlsystems entweder mit einem Kühlrippenkörper oder der genannten Kühlplatte ohne die aufwendig gestalteten mehrfach geschichteten Federelemente zur thermischen Kontaktierung der Chips wie beim EP 0 454 603 A2 der Fall, kostengünstig realisiert werden.

Eine elektrische Baugruppe mit einer Leiterplatte, wobei auf der Leiterplatte ein einen ersten Wärmestrom abgebendes erstes Bauteil und ein einen zweiten Wärmestrom abgebendes zweites Bauteil angeordnet ist, löst die eingangs genannte Aufgabe dadurch, dass die Baugruppe ein Kühlsystem oder alternativ eine Kühlplatte aufweist, wie es zuvor beschrieben wurde.

In einer Ausgestaltung der Baugruppe weist die Leiterplatte Befestigungselemente zur Befestigung des Kühlsystems auf. Um einen Anpressdruck und damit einen verringerten thermischen Kontaktwiderstand zu ermöglichen, ist zwischen einem Widerlager an dem Befestigungselement und der Leiterplatte eine Druckfeder angeordnet.

Weitere Merkmale und Ausgestaltungsvarianten zeigen die Zeichnungen. Es zeigen:

FIG 1    ein Ausführungsbeispiel für eine Flachbaugruppe mit zwei Mikroprozessoren,
FIG 2    die aus FIG 1 bekannte Flachbaugruppe mit einem Kühl- körper,
FIG 3    der Kühlkörper in einer perspektivischen Ansicht,
FIG 4    ein zweites Ausführungsbeispiel mit einer Kühlplatte,
FIG 5    die Kühlplatte aus FIG 4 in einer Unteransicht,
FIG 6    unterschiedliche Blattfedern in Kombination mit un- terschiedlichen Übertragungsmitteln und
FIG 7    ein vereinfachtes thermisches Berechnungsmodell eines Steckverbinders.

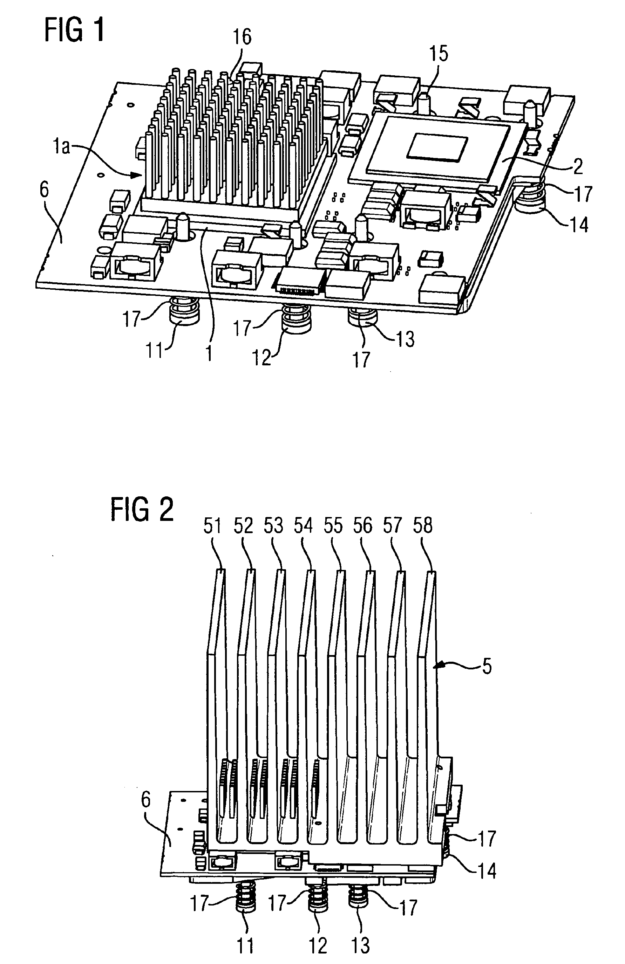

Gemäß FIG 1 ist eine Leiterplatte 6 in einer perspektivischen Ansicht dargestellt. Auf der Leiterplatte 6 sind neben einem ersten Bauteil 1 und einem zweiten Bauteil 2 eine Vielzahl von weiteren kleinen Bauteilen, wie Spulen, Widerständen, Kondensatoren, angeordnet. Das erste Bauteil 1 ist als eine erste Mikroprozessoreinheit ausgebildet und das zweite Bauteil 2 ist als eine zweite Mikroprozessoreinheit ausgebildet.

Eine derartig bestückte Leiterplatte 6 stellt eine Flachbaugruppe dar. Im Betrieb dieser Flachbaugruppe erzeugen insbesondere das erste Bauteil 1 und das zweite Bauteil 2 eine Verlustwärme. Diese Verlustwärme gilt es abzuführen. Um die Verlustwärme des ersten Bauteils 1 abzuführen, ist auf den ersten Bauteil 1 ein erstes Übertragungsmittel 1a angeordnet.

Das erste Übertragungsmittel 1a weist eine Basisplatte mit einer Unterseite und einer Oberseite auf. Auf der Oberseite ist eine Stiftstruktur angeordnet, wobei die einzelnen Stifte der Stiftstruktur im Wesentlichen senkrecht zur Oberseite der Basisplatte angeordnet sind. Aus der Basisplatte ragen somit 10x10 einzelne Stifte heraus. Diese 100 einzelnen Stifte sind, wie in FIG 2 gezeigt, in einen Kühlkörper 5 steckbar.

Jeder dieser einzelnen Stifte weist dabei einen thermischen Einzelwiderstand auf. Durch eine Parallelschaltung der thermischen Einzelwiderstände dieser 100 Stifte wird ein geringer Gesamtwiderstand erreicht als er beispielsweise über ein TIM erreichbar wäre.

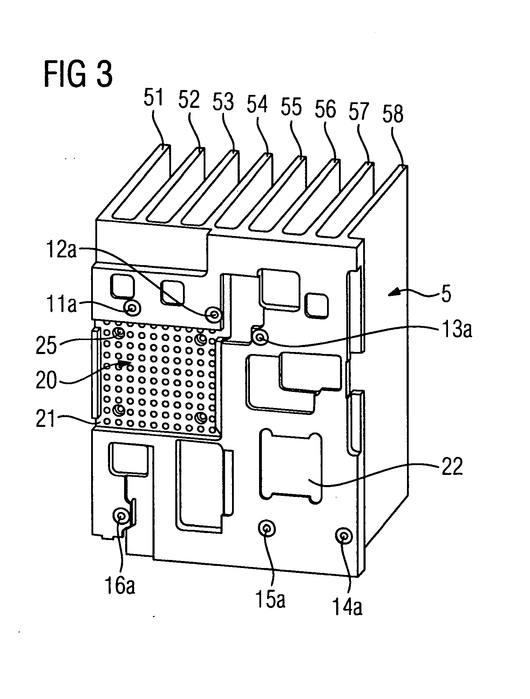

Das mit FIG 2 gezeigte Kühlsystem umfasst einen Kühlkörper 5 mit einer ersten Kontaktzone 21 und einer zweiten Kontaktzone 22 (siehe hierzu FIG 3), wobei die erste Kontaktzone 21 und die zweite Kontaktzone 22 dazu ausgestaltet sind, einen ersten Wärmestrom von dem ersten Bauteil 1 und einen zweiten Wärmestrom von dem zweiten Bauteil 2 aufzunehmen.

In der Darstellung gemäß FIG 2 wird das erste Bauteil 1 und das zweite Bauteil 2 durch den Kühlkörper verdeckt. Anhand der FIG 3 lässt sich aber verdeutlichen, dass die erste Kontaktzone 21 über das erste Übertragungsmittel 1a mit dem ersten Bauteil 1 in thermischer Verbindung steht und dass die zweite Kontaktzone 22 eine derartig ausgeformte Aussparung aufweist, dass diese auf der Oberfläche des zweiten Bauteils 2 in einer guten thermischen Verbindung zu liegen kommt. Das erste Übertragungsmittel 1a ist zwischen dem ersten Bauteil 1 und dem Kühlkörper 5 angeordnet und weist mit den 100 einzelnen Stiften ein erstes Steckmittel auf. Dieses erste Steckmittel steht mit einem im Kühlkörper 5 angeordneten ersten Durchführmittel im Eingriff und bildet dadurch eine erste Passung, wobei mittels dieser ersten Passung ein Toleranzausgleich und ein Übertragungsweg des ersten Wärmestroms in den Kühlkörper 5 realisiert sind.

Der Kühlkörper 5 ist derart auf dem zweiten Bauteil 2 mit seiner zweiten Kontaktzone 22 angeordnet, dass die zweite Kontaktzone 22 planar auf der Oberflächenkontur des zweiten Bauteils 2 aufliegt. Eine Toleranz, welche aufgrund von unterschiedlichen Höhen des ersten Bauteils 1 und des zweiten Bauteils 2 auftritt, kann durch die Stifte des Steckmittels, welches sich in den Bohrungen der Lochstruktur 20 des Kühlkörpers 5 bewegen lassen, ausgeglichen werden.

Der Kühlkörper 5 ist als ein Rippenkühlkörper mit einer ersten Kühlrippe 51 bis eine achte Kühlrippe 58 ausgestaltet. Die Bohrungen der Lochstruktur 20 sind derart in dem Kühlkörper 5 angeordnet, dass eine dritte Stiftreihe des ersten Übertragungsmittels 1a in einer Wand der zweiten Kühlrippe 52 gänzlich verschwindet. Dabei sind eine vierte und fünfte Stiftreihe des ersten Übertragungsmittels 1a zwischen der zweiten Kühlrippe 52 und der dritten Kühlrippe 53 angeordnet. Eine sechste Stiftreihe des Übertragungsmittels 1a steckt wiederum gänzlich in der dritten Kühlrippe 53.

Um eine derartige Flachbaugruppe in einer Fertigung mit dem Kühlkörper 5 zu versehen, ist es nunmehr nur noch notwendig, den Kühlkörper 5 auf dem zweiten Bauteil 2 exakt zu platzieren, wobei sich ein Toleranzausgleich für das erste Bauteil 1 zum Kühlkörper 5 durch das teleskopartig in dem Kühlkörper 5 steckende erste Übertragungsmittel 1a ergibt.

Mit der perspektivischen Ansicht in FIG 3 wird die Unteransicht des Kühlkörpers 5 deutlich und es zeigt sich in der Oberfläche der Unterseite neben der Lochstruktur 20 für die erste Kontaktzone 21, einer planaren Struktur für die zweite Kontaktzone 22, eine Mehrzahl an Vertiefungen und Ausnehmungen, welche vorzugsweise in den Kühlkörper 5 eingebracht sind, um diversen auf der Leiterplatte 6 angeordneten Bauteilen Raum zu schaffen.

Kreisförmig um die erste Kontaktzone 21 und um die zweite Kontaktzone 22 sind ein erstes Gewindeloch 11a, ein zweites Gewindeloch 12a, ein dritte Gewindeloch 13a, ein viertes Gewindeloch 14a, ein fünftes Gewindeloch 15a und ein sechstes Gewindeloch 16a im Uhrzeigersinn angeordnet. Diese Gewindelöcher 11a bis 16a dienen der Aufnahme von Befestigungselementen 11 bis 16. Die Befestigungselemente 11 bis 16 (s. FIG 2) sind dabei als eine Schraube mit einem Gewinde ausgestaltet, welche durch die Gewindelöcher 11a bis 16a aufgenommen wird. Das erste Befestigungselement 11 weist dabei an einem seiner Enden ein Widerlager in Form eines Schraubenkopfes auf, auf dem sich eine Druckfeder 17 abstützt. Diese Druckfeder 17 erzeugt einen Anpressdruck der Leiterplatte 6 gegen den Kühlkörper 5.

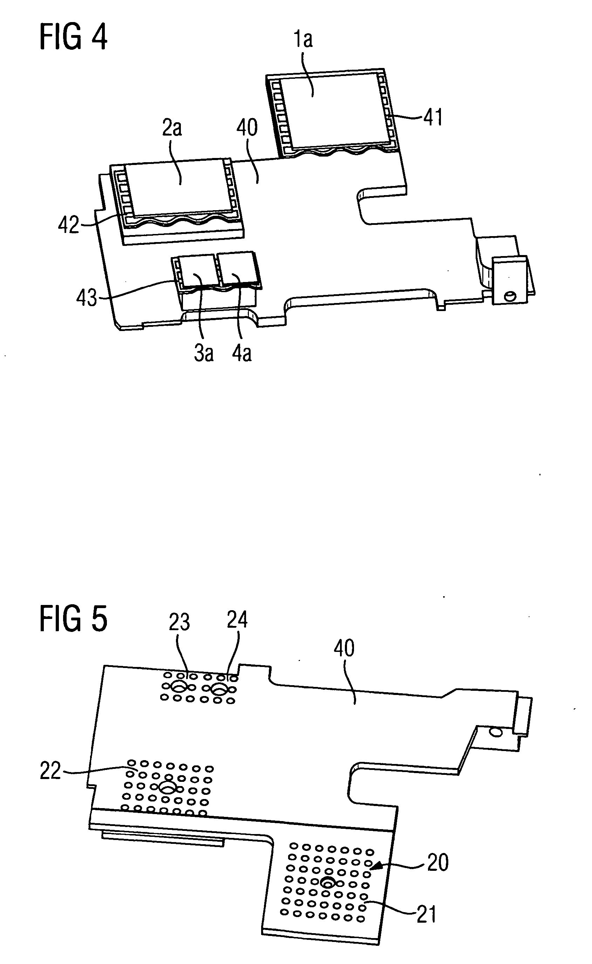

Gemäß FIG 4 und 5 wird ein zu einem Rippenkühlkörper alternatives Ausführungsbeispiel gezeigt. Eine Kühlplatte 40 weist dabei Durchführmittel für ein erstes Übertragungsmittel 1a, ein zweites Übertragungsmittel 2a, ein drittes Übertragungsmittel 3a und ein viertes Übertragungsmittel 4a an unterschiedlichen Orten der Kühlplatte 40 auf. Zwischen der Kühlplatte 40 und dem ersten Übertragungsmittel 1a ist eine erste Blattfeder 41 angeordnet. Für die weiteren drei Übertragungsmittel 2a,3a,4a sind entsprechend eine zweite Blattfeder 42 und eine dritte Blattfeder 43 zwischen der Kühlplatte 40 und den Übertragungsmitteln 2a,3a,4a angeordnet.

Eine weitere Möglichkeit einen Anpressdruck zu erzeugen, besteht darin, anstatt der Blattfedern 41, 42, 43 Druckfedern, vorzugsweise Spiralfedern, zu verwenden. Diese können im Kühlkörper (5), in entsprechenden Druckfederaufnahmen (FIG 3) montiert und geführt werden.

Eine Besonderheit bildet die dritte Blattfeder 43. Sie ist als eine gemeinsame Blattfeder für zwei unabhängig gesteckte Übertragungsmittel 3a und 4a ausgeführt. Für die Stifte der Übertragungsmittel und für die entsprechenden Lochstrukturen 20 gilt wiederum, dass diese als eine Spielpassung ausgestaltet sind.

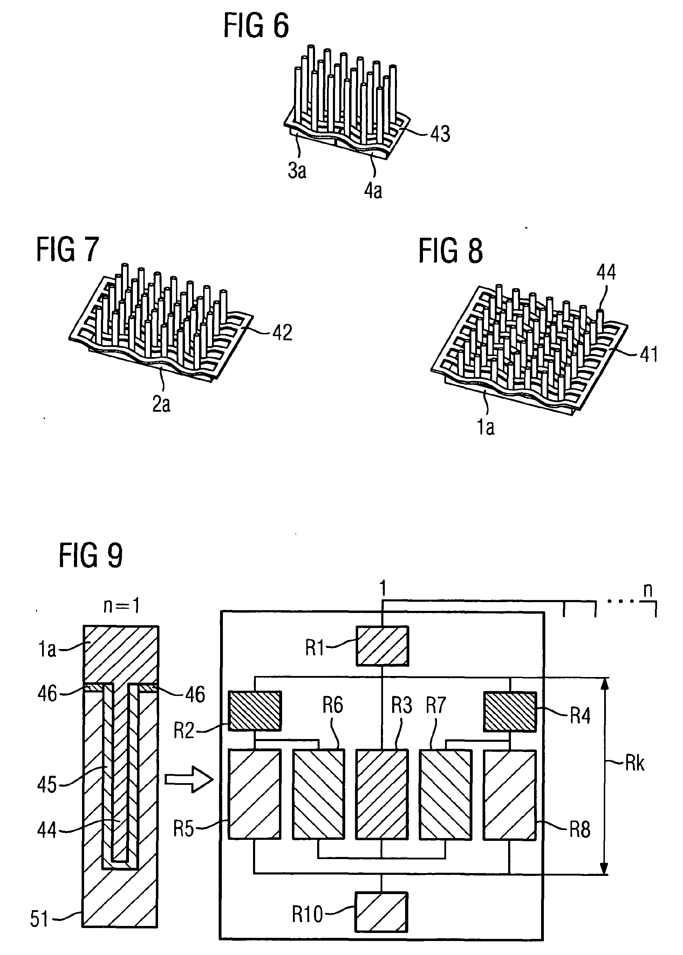

Die Figuren 6 bis 8 verdeutlichen dabei die Ausgestaltungen der Blattfedern 41,42,43. Die wellenförmig ausgestalteten Blattfedern 41,42, 43 weisen längliche Schlitze auf, wobei jeder Schlitz zur Aufnahme einer Stiftreihe des jeweiligen Übertragungsmittels 1a,2a,3a und 4a ausgestaltet ist.

Gemäß FIG 9 ist ein vereinfachtes thermisches Berechnungsmodell eines durch den Kühlkörper 5 und durch das erste Übertragungsmittel 1a realisierten Steckverbinders dargestellt. Links von dem Berechnungsmodell befindet sich exemplarisch die dritte Kühlrippe 53 des Kühlkörpers 5 in einer Schnittdarstellung. Das erste Übertragungsmittel 1a ist ebenfalls ausschnittsweise in einer Schnittdarstellung abgebildet und steckt mit einem gezeigten Stift 44 in der Bohrung, welche in der dritten Kühlrippe 53 angeordnet ist. Zwischen dem Übertragungsmittel 1a und der dritten Kühlrippe 53 befinden sich rechts und links des Stiftes 44 jeweils eine Kontaktfläche 46. Der Stift 44 steckt in der Bohrung und ist als eine Spielpassung mit umgebender Luft 45 ausgestaltet.

Zur Ableitung eines vereinfachten und prinzipiellen Berechnungsansatzes des Wärmeübertragungsmechanismus kann das Berechnungsmodell mit einem Übertragungsmittelwiderstand R1, einem Kontaktflächenwiderstand R2, einem Stiftwiderstand R3, einem weiteren Kontaktflächenwiderstand R4, einem linksseitigen Rippenwiderstand R5 und einem rechtsseitigen Rippenwiderstand R8 und einem Luftwiderstand R6, R7 mit einem Kühlkörpergesamtwiderstand RK dargestellt werden. Die vorgenannten Widerstandsbezeichnungen sind in diesem Ausführungsbeispiel ausschließlich als Wärmewiderstände anzusehen.

Aufgrund der thermischen Parallelschaltung von n-Rippe-Nut-verbindungen, wobei n = 8 für acht Kühlrippen ist und Nut als Bohrung oder Schlitz zu verstehen ist in dem/der Stift darin steckt, reicht zur prinzipiellen Beschreibung die Betrachtung einer Rippe-Nutverbindung (n = 1) aus. Eine stirnseitige Wärmeübertragung der Rippen wird dabei wegen des geringen Oberflächenanteils vernachlässigt. Es wird somit die die Wärmeübertragung über die seitlichen Luftspalte einer Rippe und dem dazugehörigen Kontaktflächen berechnet. Der Steckverbinder als Gesamtsystem wird aus der Summe der Einzelwiderstände berechnet.

Der thermische Kontaktwiderstand Rthk eines Luftspaltes (1/2 Rippe-Nut-Verbindung) ergibt sich aus:

$$R_{thk} = \cfrac{1}{\sum \left[ \cfrac{1}{R_{th2}} + \cfrac{1}{R_{th3} + R_{th6}} \right]} + R_{th5}$$

Für den Steckverbinder mit -n- Rippe-Nut-Verbindungen gilt:

$$R_{thkges} = \frac{R_{thk}}{2 * n}$$

**Patentansprüche**

1. Kühlsystem umfassend

   - einen Kühlkörper (5) mit
   - einer ersten Kontaktzone (21) und
   - einer zweiten Kontaktzone (22),
   welche ausgestaltet sind zur Aufnahme
   - eines ersten Wärmestroms von einem ersten Bauteil (1) und
   - eines zweiten Wärmestroms von einem zweiten Bauteil(2),
   - ein erstes Übertragungsmittel (1a) zur Übertragung des ersten Wärmestromes über die erste Kontaktzone (21) in den Kühlkörper (5),

   wobei das erste Übertragungsmittel (1a) zwischen dem ersten Bauteil (1) und dem Kühlkörper (5) angeordnet ist und ein erstes Steckmittel aufweist, welches dergestalt ausgeformt ist, dass das erste Steckmittel mit einem im Kühlkörper (5) angeordnetem ersten Durchführmittel eine erste Passung bildet, wobei mittels der ersten Passung ein Toleranzausgleich und ein Übertragungsweg des ersten Wärmestromes in den Kühlkörper (5) realisiert ist, **dadurch gekennzeichnet, dass** das erste Übertragungsmittel (la) eine Unterseite und eine Oberseite aufweist, wobei die Unterseite ausgestaltet ist um sich einer Kontur des ersten Bauteils (1) anzupassen und die Oberseite mit einer Anordnung von Stiften und/oder Stegen versehen ist.

2. Kühlsystem nach Anspruch 1, wobei zwischen dem ersten Übertragungsmittel (la) und dem Kühlkörper (5) ein erstes Federelement (41) angeordnet ist.

3. Kühlsystem nach einem der Ansprüche 1 oder 2, wobei die Durchführmittel als eine Anordnung (20) von einer Mehrzahl von Löchern, insbesondere Bohrungen, oder Schlitzen ausgestaltet ist.

4. Kühlsystem nach einem der Ansprüche 1 bis 3, wobei die Passung als eine Spielpassung ausgestaltet ist.

5. Kühlsystem nach einem der Ansprüche 1 bis 4, wobei die Passung abschnittsweise als ein Schiebstück ausgestaltet ist.

6. Kühlsystem nach einem der Ansprüche 1 bis 5, wobei das erste Übertragungsmittel (1a) zumindest teilweise die Materialien Aluminium und/oder Kupfer und/oder Zink-Druckguß und/oder Graphit aufweist.

7. Kühlsystem nach einem der Ansprüche 1 bis 6, wobei eine das Übertragungsmittel (1a) aufweisende Basisplatte auf der die Steckmittel im Wesentlichen senkrecht dazu angeordnet sind aus Graphit gefertigt ist.

8. Kühlsystem nach einem der Ansprüche 2 bis 7, wobei das Federelement (41) als eine wellenförmige Blattfeder ausgestaltet ist.

9. Kühlsystem nach einem der Ansprüche 2 bis 8, aufweisend Befestigungsmittel zur Befestigung auf einer Leiterplatte (6).

10. Kühlplatte (40) umfassend

    - eine erste Kontaktzone (21),
    - eine zweite Kontaktzone (22),
    ausgestaltet zur Aufnahme eines
    - ersten Wärmestroms von einem ersten Bauteil (1) und
    - eines zweiten Wärmestroms eines zweiten Bauteils(2),

    **dadurch gekennzeichnet, dass** die erste Kontaktzone (21) mit einer Anordnung von einer Mehrzahl von Löchern oder Schlitzen ausgestaltet ist, und die zweite Kontaktzone (22) mit einer weiteren Anordnung mit einer Mehrzahl von Löchern oder Schlitzen ausgestaltet ist, um einen Toleranzausgleich bei der Anordnung des ersten Bauteils (1) in der ersten Kontaktzone (21) und des zweiten Bauteils (2) in der zweiten Kontaktzone (22) im Hinblick auf eine gemeinsame Entwärmung der Bauteile (1,2) zu ermöglichen.

**11.** Elektrische Baugruppe mit einer Leiterplatte (6), wobei auf der Leiterplatte (6)

- ein einen ersten Wärmestrom abgebendes erstes Bauteil (1) und
- ein einen zweiten Wärmestrom abgebendes zweites Bauteil (2), angeordnet ist,

**gekennzeichnet durch** ein Kühlsystem nach einem der Ansprüche 1 bis 9.

**12.** Elektrische Baugruppe nach Anspruch 11, wobei die Leiterplatte (6) Befestigungselemente (11,...,16) zur Befestigung des Kühlsystems aufweist.

**13.** Elektrische Baugruppe nach Anspruch 12, wobei zwischen einem Widerlager an dem Befestigungselement (11,..., 16) und der Leiterplatte (6) eine Druckfeder (17) angeordnet ist.

**Claims**

**1.** Cooling system comprising

- a heat sink (5) having
- a first contact zone (21) and
- a second contact zone (22),
which are designed to absorb
- a first heat flow from a first component (1) and
- a second heat flow from a second component (2), and
- a first transmission means (1a) for transmission of the first heat flow via the first contact zone (21) into the heat sink (5),

wherein the first transmission means (1a) is arranged between the first component (1) and the heat sink (5) and has a first plug means which is shaped such that the first plug means forms a first fit with a first bushing means which is arranged in the heat sink (5), wherein the first fit provides tolerance compensation and a transmission path for the first heat flow into the heat sink (5),
**characterized in that** the first transmission means (1a) has a lower face and an upper face, wherein the lower face is designed to match a contour of the first component (1), and the upper face is provided with an arrangement of pins and/or webs.

**2.** Cooling system according to Claim 1, wherein a first spring element (41) is arranged between the first transmission means (1a) and the heat sink (5).

**3.** Cooling system according to Claim 1 or 2, wherein the bushing means is in the form of an arrangement (20) of a plurality of holes, in particular drilled holes, or slots.

**4.** Cooling system according to one of Claims 1 to 3, wherein the fit is in the form of a clearance fit.

**5.** Cooling system according to one of Claims 1 to 4, wherein the fit is in the form of a sliding piece, in places.

**6.** Cooling system according to one of Claims 1 to 5, wherein the first transmission means (1a) is composed at least partially of the materials aluminum and/or copper and/or die-cast zinc and/or graphite.

**7.** Cooling system according to one of Claims 1 to 6, wherein a base plate which has the transmission means (1a) and on which the plug means are arranged, essentially at right angles thereto, is manufactured from graphite.

**8.** Cooling system according to one of Claims 2 to 7, wherein the spring element (41) is in the form of a corrugated leaf spring.

**9.** Cooling system according to one of Claims 2 to 8, having mounting means for mounting on a printed circuit board (6).

**10.** Cold plate (40) having

- a first contact zone (21), and
- a second contact zone (22),
designed for absorbing
- a first heat flow from a first component (1) and
- a second heat flow from a second component (2),

**characterized in that** the first contact zone (21) is designed with an arrangement of a plurality of holes or slots, and the second contact zone (22) is designed with a further arrangement having a plurality of holes or slots in order to allow tolerance compensation in the arrangement of the first component (1) in the first contact zone (21) and of the second component (2) in the second contact zone (22) with respect to joint heat dissipation from the components (1, 2).

11. Electrical assembly having a printed circuit board (6), wherein

     - a first component (1) which emits a first heat flow, and
     - a second component (2) which emits a second heat flow, are arranged on the printed circuit board (6),

**characterized by** a cooling system according to one of Claims 1 to 9.

12. Electrical assembly according to Claim 11, wherein the printed circuit board (6) has mounting elements (11,...,16) for mounting the cooling system.

13. Electrical assembly according to Claim 12, wherein a compression spring (17) is arranged between an opposing bearing on the mounting element (11,...,16) and the printed circuit board (6).


**Revendications**

1. Système de refroidissement comprenant

     - un dissipateur de chaleur ( 5 ) ayant
     - une première zone ( 21 ) de contact et
     - une deuxième zone ( 22 ) de contact
     qui sont constituées pour l'absorption
     - d'un premier flux calorifique d'un premier composant ( 1 ) et
     - d'un deuxième flux calorifique d'un deuxième composant ( 2 ),
     - un premier moyen ( 1a ) de transmission pour la transmission du premier flux calorifique par la première zone ( 21 ) de contact au dissipateur de chaleur ( 5 ),

dans lequel le premier moyen ( 1a ) de transmission est monté entre le premier composant ( 1 ) et le dissipateur de chaleur ( 5 ) et a un premier moyen d'enfichage conformé de manière à ce que le premier moyen d'enfichage forme un premier ajustement avec un premier moyen de passage disposé dans le dissipateur de chaleur ( 5 ), une compensation des tolérances et un trajet de transmission du premier flux calorifique dans le dissipateur de chaleur ( 5 ) étant réalisé à l'aide du premier ajustement,
**caractérisé en ce que** le premier moyen ( 1a ) de transmission a un côté inférieur et un côté supérieur, le côté inférieur étant conformé pour s'adapter à un contour du premier composant ( 1 ) et le côté supérieur étant muni d'un agencement de broches et/ou de nervures.

2. Système de refroidissement suivant la revendication 1, dans lequel un premier élément ( 41 ) de ressort est monté entre le premier moyen ( 1a ) de transmission et le dissipateur de chaleur ( 5 ).

3. Système de refroidissement suivant la revendication 1 ou 2, dans lequel le moyen de passage est sous la forme d'un agencement ( 20 ) d'une multiplicité de trous, notamment d'alésages ou de fentes.

4. Système de refroidissement suivant l'une des revendications 1 à 3, dans lequel l'ajustement est conformé en ajustement avec jeu.

5. Système de refroidissement suivant l'une des revendications 1 à 4, dans lequel l'ajustement est conformé par endroit sous la forme d'un coulisseau.

6. Système de refroidissement suivant l'une des revendications 1 à 5, dans lequel le premier moyen ( 1a ) de transmission comporte au moins en partie les matériaux aluminium et/ou cuivre et/ou zinc coulé sous pression et/ou graphite.

7. Système de refroidissement suivant l'une des revendications 1 à 6, dans lequel une plaque de base, qui a le moyen ( 1a ) de transmission et sur laquelle les moyens d'enfichage sont disposés sensiblement perpendiculairement, est en graphite.

8. Système de refroidissement suivant l'une des revendications 2 à 7, dans lequel l'élément ( 41 ) de ressort est conformé en ressort à lame ondulé.

9. Système de refroidissement suivant l'une des revendications 2 à 8, ayant des moyens de fixation pour la fixation d'une plaquette ( 6 ) à circuit imprimé.

10. Plaque ( 40 ) de refroidissement comprenant

    - une première zone ( 21 ) de contact,
    - une deuxième zone ( 22 ) de contact,
    conformées pour l'absorption d'un
    - premier flux calorifique d'un premier composant ( 1 ) et
    - d'un deuxième flux calorifique d'un deuxième composant ( 2 ),

    **caractérisée en ce que** la première zone ( 21 ) de contact est conformée en ayant un agencement d'une multiplicité de trous ou de fentes et la deuxième zone ( 22 ) de contact est conformée, en ayant un autre agencement ayant une multiplicité de trous ou de fentes, pour permettre une compensation des tolérances dans l'agencement du premier composant ( 1 ) dans la première zone ( 21 ) de contact et du deuxième composant ( 2 ) dans la deuxième zone ( 22 ) de contact en vue d'une dissipation commune de la chaleur des composants ( 1, 2 ).

11. Module électrique comprenant une plaquette ( 6 ) à circuit imprimé, dans lequel il est monté sur la plaquette ( 6 ) à circuit imprimé

    - un premier composant ( 1 ) cédant un premier flux calorifique et
    - un deuxième composant ( 2 ) cédant un deuxième flux calorifique,

    **caractérisé par** un système de refroidissement suivant l'une des revendications 1 à 9.

12. Composant électrique suivant la revendication 11, dans lequel la plaquette ( 6 ) à circuit imprimé a des éléments ( 11, ..., 16 ) de fixation pour la fixation du système de refroidissement.

13. Composant électrique suivant la revendication 12, dans lequel un ressort ( 17 ) de compression est monté entre une butée sur l'élément ( 11, ..., 16 ) de fixation et la plaquette ( 6 ) à circuit imprimé.

FIG 1

16

15

1a

6

2

17

14

17

11    1    12    17    13

17

FIG 2

51  52  53  54  55  56  57  58

5

6

17

14

17    17    17

11    12    13

# FIG 3

FIG 4

FIG 5

## FIG 6

43

3a

4a

## FIG 7

42

2a

## FIG 8

44

41

1a

## FIG 9

n=1

1a

46          46

R2

45

44

51

1                    n

R1

R6    R3    R7    R4

Rk

R5                        R8

R10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5787576 A
- EP 0454603 A2